# EUROPEAN PATENT APPLICATION

(11) **EP 4 155 010 A1**
(43) Date of publication of application: **29.03.2023**
(21) Application number: 22194327.7
(22) Date of filing: 07.09.2022
(51) Int. Cl.: B22F 10/22, B22F 12/58, C23C 14/00, C23C 16/00, B33Y 10/00, B33Y 30/00, B33Y 70/00, C23C 18/16

(54) **ALLOYING OF METAL JETTING COMPOSITIONS AND METHODS THEREOF**

(30) Priority: 27.09.2021 US 202117448940
(71) Applicant: Xerox Corporation, Webster, NY 14580 (US)
(72) Inventor: FLETCHER, Colin Gray, Webster, 14580 (US); MIKA, Mariusz Tadeusz, Webster, 14580 (US); MOSCHEL, Miranda, Webster, 14580 (US); HELLER, Daimon, Webster, 14580 (US)
(74) Representative: Grünecker Patent- und Rechtsanwälte PartG mbB

(57) **Abstract**

A system for jetting metal is also disclosed, which includes a nozzle orifice in connection with the inner cavity and configured to eject one or more droplets of liquid metal, a source of printing material located external to the ejector, and an alloying system located between the source of printing material and the ejector. A method for metal jetting is disclosed, which includes introducing a printing material from a feed source into an alloying system. The method for metal jetting also includes depositing an alloying material within the alloying system onto the printing material to produce an alloyed printing material, introducing the alloyed printing material into an ejector defining a cavity which can retain a printing material, melting the alloyed printing material in the cavity of the ejector, ejecting the alloyed printing material from the ejector.

## Description

### Technical Field

The present teachings relate generally to drop-on-demand jetting and, more particularly, to apparatus and methods for jetting alloyed metal compositions.

### Background

An additive manufacturing method involving drop-on-demand (DOD) or three-dimensional (3D) printer builds (e.g., prints) a 3D object from a computer-aided design (CAD) model, usually by successively depositing material layer upon layer. A drop-on-demand (DOD), particularly one that prints a metal or metal alloy, ejects a small drop of liquid aluminum alloy when a firing pulse is applied. Using this technology, a 3D part or other materials can be created from aluminum, another alloy, or material by ejecting a series of drops which bond together to form a continuous part. For example, a first layer may be deposited upon a substrate, which is configured to support deposited ink or printed 3D parts and then a second layer may be deposited upon the first layer. One particular type of 3D printer is a magnetohydrodynamic (MHD) printer, which is suitable for jetting liquid metal layer upon layer to form a 3D metallic object. Magnetohydrodynamic refers to the study of the magnetic properties and the behavior of electrically conducting fluids. Metal wire and rod are generally available only in high-volume alloys which are profitable for manufacturers to produce. Custom compositions, even with slight modifications, must be procured at an increased expense, typically in larger quantities with significant lead time, with minimum orders of approximately 2000-3000 pounds. This makes alloy modification difficult and time consuming for development purposes.

While the metallic wire drawing process is relatively simple, it requires specialized equipment and several process steps to physically produce wire. Additionally, the process consists of casting an ingot of a certain chemical composition, forming the ingot to a feedstock suitable for wire drawing, which is followed by repeated reduction and thermal annealing steps until a final wire diameter is achieved. Rod feed material is produced in a similar manner, but typically rolled or extruded to a final dimension. These processes are currently the only route to obtain nonstandard compositions of wire or rod. This can be a costly solution, as material applications generally require completely homogeneous compositions. Within some liquid metal jetting processes that use wire or rod as feed material, a homogeneous composition is not necessary due to remelting of the input material within an inner cavity of the ejector. As such, alloying additions may be made to the surface of the input material and integrated during the melting process prior to jetting. Furthermore, additive manufacturing of metallic materials with graduated chemical compositions currently requires input material of graduated composition, for example, different powder compositions.

Therefore, it is desirable to have an additive manufacturing or liquid metal jetting method with enabled dynamically modified input stock to provide greater flexibility and capability in printing graduated compositions and other custom alloyed materials.

### Summary

The following presents a simplified summary in order to provide a basic understanding of some aspects of one or more embodiments of the present teachings. This summary is not an extensive overview, nor is it intended to identify key or critical elements of the present teachings, nor to delineate the scope of the disclosure. Rather, its primary purpose is merely to present one or more concepts in simplified form as a prelude to the detailed description presented later.

A method for metal jetting is disclosed. The method for metal jetting also includes introducing a printing material from a feed source into an alloying system. The method for metal jetting also includes depositing an alloying material within the alloying system onto the printing material to produce an alloyed printing material. The method for metal jetting also includes introducing the alloyed printing material into an ejector defining a cavity which can retain a printing material. The method for metal jetting also includes melting the alloyed printing material in the cavity of the ejector. The method also includes ejecting the alloyed printing material from the ejector.

The method for metal jetting where the printing material may include a wire or a rod. The alloying system may include a physical vapor deposition process. The physical vapor deposition process further may include a sputter deposition process. The alloying system may include an electroplating process. The alloying system may include an electroless plating process. The alloying system may include a chemical vapor deposition process. The method for metal jetting may include mixing the printing material and the alloying material within the cavity of the ejector after introducing the alloyed printing material into the cavity of the ejector which can retain a printing material. The method for metal jetting may include adjusting an amount of the alloying material relative to an amount of the printing material by adjusting a feed rate of the printing material. The method for metal jetting may include adjusting an amount of the alloying material relative to an amount of the printing material by adjusting a parameter in the alloying system. The printing material may include a metal, element, metallic alloy, or a combination thereof. The printing material may further include aluminum, aluminum alloys, or a combination thereof. The alloying material may include a metal, element, metallic alloy, or a combination thereof. The alloying material may include strontium. A content of alloying material in the alloyed printing material may be from about 0.1% to about 10% of total weight of the alloyed printing material. A content of alloying material in the alloyed printing material may be from about 1 ppm to about 200 ppm of total weight of the alloyed printing material.

A system for jetting metal is disclosed. The system for jetting metal may include a nozzle orifice in connection with the inner cavity and configured to eject one or more droplets of liquid metal, a source of printing material located external to the ejector, and an alloying system located between the source of printing material and the ejector. The system for jetting metal may also include where the source of printing material is configured to introduce the printing material into the alloying system and then into the inner cavity of the ejector.

The system for jetting metal may include a heating element configured to heat a solid in the inner cavity of the ejector, thereby causing the solid to change to a liquid within the ejector. The system for jetting metal may include a coil wrapped at least partially around the ejector, and a power source configured to supply one or more pulses of power to the coil, which cause the one or more droplets of liquid metal to be jetted out of the nozzle orifice. The alloying system may include a physical vapor deposition apparatus.

### Brief Description of the Drawings

The accompanying drawings, which are incorporated in and constitute a part of this specification, illustrate embodiments of the present teachings and together with the description, serve to explain the principles of the disclosure. In the figures:
FIG. 1 depicts a schematic cross-sectional view of a single liquid ejector jet of a 3D printer (e.g., a MHD printer and/or multi-jet printer), according to an embodiment.
FIG. 2 is a schematic cross-sectional view of a single liquid ejector jet of a metal jetting printing system configured for jetting alloyed metal compositions, according to an embodiment.
FIG. 3 is a flowchart illustrating a method of metal jetting an alloyed metal, according to an embodiment.

It should be noted that some details of the figures have been simplified and are drawn to facilitate understanding of the present teachings rather than to maintain strict structural accuracy, detail, and scale.

### Detailed Description

Reference will now be made in detail to exemplary embodiments of the present teachings, examples of which are illustrated in the accompanying drawings. Wherever possible, the same reference numbers will be used throughout the drawings to refer to the same, similar, or like parts.

Known liquid metal jetting processes typically use wire or rod as feed material, but these feed materials are generally available at reasonable cost only for alloys produced in large volumes. Custom compositions, even with slight modifications, can be economically and schedule prohibitive, making alloy modification difficult and time consuming for development purposes. An additive manufacturing or liquid metal jetting method having enabled dynamically modified input stock could provide greater flexibility and capability in printing graduated compositions and other custom alloyed materials. Exemplary embodiments described herein provides an in-process deposition of one or more alloying elements onto a surface of input feed material for additive manufacturing. Proposed embodiments would deposit alloying elements onto the surface of an input wire or rod prior to melting in a melt pool or ejector cavity of an additive manufacturing machine. Such modification would take place in the normal input material feed path into the machine by first routing the printing material through an alloying subsystem. Example alloying subsystems include deposition processes such as sputtering, electroplating, electroless plating, chemical vapor deposition (CVD), physical vapor deposition (PVD), or combinations thereof.

Once inside the additive manufacturing ejector, the deposited elements would be mixed into the alloy while in the molten state while residing within or while being retained within the melt pool in the inner cavity of an ejector. In-process alloy modification using methods according to one or more embodiments herein may enable controlled adjustments to composition for the purposes of grain refinement, strengthening, oxidation prevention, gradient compositions, and the like. Input printing material feeds could also be coated or alloyed prior to being fed into the machine in an alloying process as well.

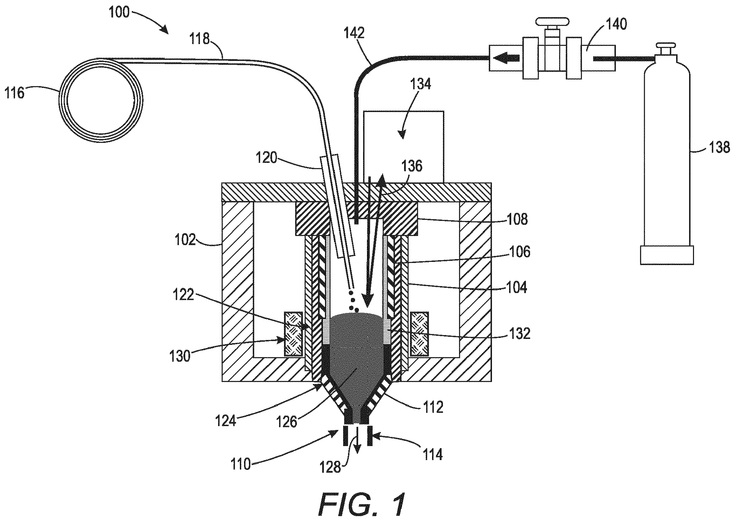

FIG. 1 depicts a schematic cross-sectional view of a single liquid ejector jet of a 3D printer (e.g., a MHD printer and/or multi-jet printer), according to an embodiment. FIG. 1 shows a portion of a type of drop-on-demand (DOD) or three-dimensional (3D) printer 100. The 3D printer or liquid ejector jet system 100 may include an ejector (also referred to as a body or pump chamber, or a "one-piece" pump) 104 within an outer ejector housing 102, also referred to as a lower block. The ejector 104 may define an inner volume 132 (also referred to as an internal cavity). A printing material 126 may be introduced into the inner volume 132 of the ejector 104. The printing material 126 may be or include a metal, a polymer, or the like. For example, the printing material 126 may be or include aluminum or aluminum alloy, introduced via a printing material supply 116 or spool of a printing material wire feed 118, in this case, an aluminum wire. The liquid ejector jet system 100 further includes a first inlet 120 within a pump cap or top cover portion 108 of the ejector 104 whereby the printing material wire feed 118 is introduced into the inner volume 132 of the ejector 104. The ejector 104 further defines a nozzle 110, an upper pump 122 area and a lower pump 124 area. One or more heating elements 112 are distributed around the pump chamber 104 to provide an elevated temperature source and maintain the printing material 126 in a molten state during printer operation. The heating elements 112 are configured to heat or melt the printing material wire feed 118, thereby changing the printing material wire feed 118 from a solid state to a liquid state (e.g., printing material 126) within the inner volume 132 of the ejector 104. The three-dimensional 3D printer 100 and ejector 104 may further include an air or argon shield 114 located near the nozzle 110, and a water coolant source 130 to further enable nozzle and/or ejector 104 temperature regulation. The liquid ejector jet system 100 further includes a level sensor 134 system which is configured to detect the level of molten printing material 126 inside the inner volume 132 of the ejector 104 by directing a detector beam 136 towards a surface of the printing material 126 inside the ejector 104 and reading the reflected detector beam 136 inside the level sensor 134.

The 3D printer 100 may also include a power source, not shown herein, and one or more metallic coils 106 enclosed in a pump heater that are wrapped at least partially around the ejector 104. The power source may be coupled to the coils 106 and configured to provide an electrical current to the coils 106. An increasing magnetic field caused by the coils 106 may cause an electromotive force within the ejector 104, that in turn causes an induced electrical current in the printing material 126. The magnetic field and the induced electrical current in the printing material 126 may create a radially inward force on the printing material 126, known as a Lorenz force. The Lorenz force creates a pressure at an inlet of a nozzle 110 of the ejector 104. The pressure causes the printing material 126 to be jetted through the nozzle 110 in the form of one or more liquid drops 128.

The 3D printer 100 may also include a substrate, not shown herein, that is positioned proximate to (e.g., below) the nozzle 110. The ejected drops 128 may land on the substrate and solidify to produce a 3D object. The 3D printer 100 may also include a substrate control motor that is configured to move the substrate while the drops 128 are being jetted through the nozzle 110, or during pauses between when the drops 128 are being jetted through the nozzle 110, to cause the 3D object to have the desired shape and size. The substrate control motor may be configured to move the substrate in one dimension (e.g., along an X axis), in two dimensions (e.g., along the X axis and a Y axis), or in three dimensions (e.g., along the X axis, the Y axis, and a Z axis). In another embodiment, the ejector 104 and/or the nozzle 110 may be also or instead be configured to move in one, two, or three dimensions. In other words, the substrate may be moved under a stationary nozzle 110, or the nozzle 110 may be moved above a stationary substrate. In yet another embodiment, there may be relative rotation between the nozzle 110 and the substrate around one or two additional axes, such that there is four or five axis position control. In certain embodiments, both the nozzle 110 and the substrate may move. For example, the substrate may move in X and Y directions, while the nozzle 110 moves up and/or down in a Y direction.

The 3D printer 100 may also include one or more gas-controlling devices, which may be or include a gas source 138. The gas source 138 may be configured to introduce a gas. The gas may be or include an inert gas, such as helium, neon, argon, krypton, and/or xenon. In another embodiment, the gas may be or include nitrogen. The gas may include less than about 10% oxygen, less than about 5% oxygen, or less than about 1% oxygen. In at least one embodiment, the gas may be introduced via a gas line 142 which includes a gas regulator 140 configured to regulate the flow or flow rate of one or more gases introduced into the three-dimensional 3D printer 100 from the gas source 138. For example, the gas may be introduced at a location that is above the nozzle 110 and/or the heating element 112. This may allow the gas (e.g., argon) to form a shroud/sheath around the nozzle 110, the drops 128, the 3D object, and/or the substrate to reduce/prevent the formation of oxide (e.g., aluminum oxide) in the form of an air shield 114. Controlling the temperature of the gas may also or instead help to control (e.g., minimize) the rate that the oxide formation occurs.

The liquid ejector jet system 100 may also include an enclosure 102 that defines an inner volume (also referred to as an atmosphere). In one embodiment, the enclosure 102 may be hermetically sealed. In another embodiment, the enclosure 102 may not be hermetically sealed. In one embodiment, the ejector 104, the heating elements 112, the power source, the coils, the substrate, additional system elements, or a combination thereof may be positioned at least partially within the enclosure 102. In another embodiment, the ejector 104, the heating elements 112, the power source, the coils, the substrate, additional system elements, or a combination thereof may be positioned at least partially outside of the enclosure 102.

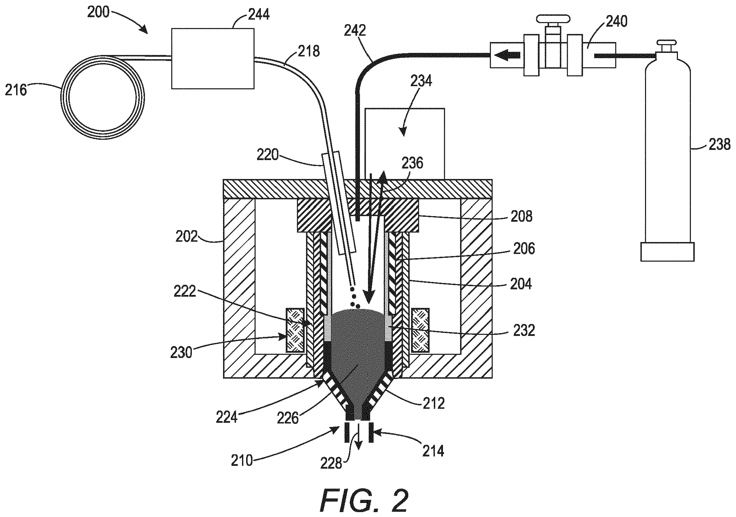

FIG. 2 is a schematic cross-sectional view of a single liquid ejector jet of a metal jetting printing system configured for jetting alloyed metal compositions, according to an embodiment. FIG. 2 shows a portion of a type of drop-on-demand (DOD) or three-dimensional (3D) printer 200. The 3D printer or liquid ejector jet system 200 may include an ejector 204 within an outer ejector housing 202, also referred to as a lower block. The ejector 204 may define an inner volume 232. An alloyed printing material 226 may be introduced into the inner volume 232 of the ejector 204. The alloyed printing material 226 may be or include a metal, a polymer, or the like. For example, the alloyed printing material 226 may be or include aluminum alloy, introduced via a printing material supply 216 or spool of a printing material wire feed 218, in this case, beginning with an aluminum wire. As the printing material wire feed 218 is introduced into the liquid ejector jet system 200, the printing material wire feed 218 is routed through an alloying subsystem 244, located between the source of printing material and the ejector, where the printing material wire feed 218 is subjected to one or more processes to introduce additional alloying materials into the surface of the printing material wire feed 218. The printing material supply 216 or source of printing material is configured to introduce the printing material into the alloying system 244 and then into the inner cavity 232 or inner volume of the ejector 204. In certain embodiments, the alloying system 244 may include a physical vapor deposition (PVD) apparatus. Alternate embodiments may include deposition processes such as the aforementioned physical vapor deposition (PVD), sputtering, electroplating, electroless plating, cold spray processes using powders or cold weld materials, chemical vapor deposition (CVD), or a combination thereof. Additional deposition processes suitable for use may include thermal spray processes, hot dip processes, or other dip, spray, conversion coatings, or combinations thereof, in certain embodiments. Gradient compositions of the alloyed and printed material may be achieved by the rate of feed of input printing material being adjusted, as well as parameters within the deposition or alloying process being adjusted. While the embodiments described herein utilize wire or rod printing material sources, other embodiments may include the use of pellets or small ingots, depending on the size of the crucible or the ejector as printing material sources.

The liquid ejector jet system 200 further includes a first inlet 220 within a pump cap or top cover portion 208 of the ejector 204 whereby the printing material wire feed 218 is introduced into the inner volume 232 of the ejector 204. The ejector 204 further defines a nozzle 210, an upper pump 222 area and a lower pump 224 area. One or more heating elements 212 are distributed around the pump chamber 204 to provide an elevated temperature source and maintain the printing material 226 in a molten state during printer operation. The heating elements 212 are configured to heat or melt the printing material wire feed 218, thereby changing the printing material wire feed 218 from a solid state to a liquid state within the inner volume 232 of the ejector 204. The three-dimensional 3D printer 200 and ejector 204 may further include an air or argon shield 214 located near the nozzle 210, and a water coolant source 230 to further enable nozzle and/or ejector 204 temperature regulation. The liquid ejector jet system 200 further includes a level sensor 234 system which is configured to detect the level of molten alloyed printing material 226 inside the inner volume 232 of the ejector 204 by directing a detector beam 236 towards a surface of the alloyed printing material 226 inside the ejector 104 and reading the reflected detector beam 236 inside the level sensor 234.

The 3D printer 200 may also include a power source, not shown herein, and one or more metallic coils 206 enclosed in a pump heater that are wrapped at least partially around the ejector 204. The power source may be coupled to the coils 206 and configured to provide an electrical current to the coils 206. An increasing magnetic field caused by the coils 206 may cause an electromotive force within the ejector 204, that in turn causes an induced electrical current in the alloyed printing material 226. The magnetic field and the induced electrical current in the alloyed printing material 226 may create a radially inward force on the alloyed printing material 226, known as a Lorenz force. The Lorenz force creates a pressure at an inlet of a nozzle 210 of the ejector 204. The pressure causes the alloyed printing material 226 to be jetted through the nozzle 210 in the form of one or more liquid drops 228, which in this case are alloyed printing material liquid drops 228.

The 3D printer 200 may also include a substrate, not shown herein, that is positioned proximate to (e.g., below) the nozzle 210. The ejected drops 228 may land on the substrate and solidify to produce a 3D object. The 3D printer 200 may also include a substrate control motor that is configured to move the substrate while the drops 228 are being jetted through the nozzle 210, or during pauses between when the drops 228 are being jetted through the nozzle 210, to cause the 3D object to have the desired shape and size. The substrate control motor may be configured to move the substrate in one dimension (e.g., along an X axis), in two dimensions (e.g., along the X axis and a Y axis), or in three dimensions (e.g., along the X axis, the Y axis, and a Z axis). In another embodiment, the ejector 204 and/or the nozzle 210 may be also or instead be configured to move in one, two, or three dimensions. In other words, the substrate may be moved under a stationary nozzle 210, or the nozzle 210 may be moved above a stationary substrate. In yet another embodiment, there may be relative rotation between the nozzle 210 and the substrate around one or two additional axes, such that there is four or five axis position control. In certain embodiments, both the nozzle 210 and the substrate may move. For example, the substrate may move in X and Y directions, while the nozzle 210 moves up and/or down in a Y direction. The 3D printer 200, in the manners mentioned previously, but not limited to those specifically described, may then produce a 3D component or part, made of material directly from the printing material supply 216 or as alloyed after passing through the alloying subsystem 244. It should be noted that more than one alloying element or alloying source material may be introduced into the printing material supply 216 by using the alloying subsystem 244. Furthermore, the alloying subsystem 244 may be turned on, turned off, or have one or more parameters of the alloying subsystem 244 adjusted during operation to create a part of varying alloy composition while printing operations are taking place. The composition of alloying element may be adjusted either in a stepwise manner, a gradual or gradient manner, or a combination of both. Examples of alloying elements may include, in certain embodiments, electroplating copper or zinc onto an aluminum printing material feed stock, sputtering strontium onto an aluminum printing material feed stock, electroless plating of nickel onto a steel printing material feed stock, or combinations thereof. Exemplary examples of printing material sources used in embodiments described herein include aluminum, copper, iron, nickel, and their alloys. Exemplary examples of alloying material sources used in embodiments described herein include aluminum, copper, iron, nickel, and their alloys.

The 3D printer 200 may also include one or more gas-controlling devices, which may be or include a gas source 238. The gas source 238 may be configured to introduce a gas. The gas may be or include an inert gas, such as helium, neon, argon, krypton, and/or xenon. In another embodiment, the gas may be or include nitrogen. The gas may include less than about 10% oxygen, less than about 5% oxygen, or less than about 1% oxygen. In at least one embodiment, the gas may be introduced via a gas line 242 which includes a gas regulator 240 configured to regulate the flow or flow rate of one or more gases introduced into the three-dimensional 3D printer 200 from the gas source 238. For example, the gas may be introduced at a location that is above the nozzle 210 and/or the heating element 212. This may allow the gas (e.g., argon) to form a shroud/sheath around the nozzle 210, the drops 228, the 3D object, and/or the substrate to reduce/prevent the formation of oxide (e.g., aluminum oxide with the use of an aluminum printing material) in the form of an air shield 214. Controlling the temperature of the gas may also or instead help to control (e.g., minimize) the rate that the oxide formation occurs. It should also be noted that the gas source may be modified or blended with an input into the alloying subsystem 244 in certain embodiments for the purpose of further enhancing the alloying process or modifying the alloy composition in combination with the alloying materials introduced to the source of printing material 216 via the alloying subsystem 244.

The liquid ejector jet system 200 may also include an enclosure 202 that defines an inner volume (also referred to as an atmosphere). In one embodiment, the enclosure 202 may be hermetically sealed. In another embodiment, the enclosure 202 may not be hermetically sealed. In one embodiment, the ejector 204, the heating elements 212, the power source, the coils, the substrate, additional system elements, or a combination thereof may be positioned at least partially within the enclosure 202. In another embodiment, the ejector 204, the heating elements 112, the power source, the coils, the substrate, additional system elements, or a combination thereof may be positioned at least partially outside of the enclosure 202.

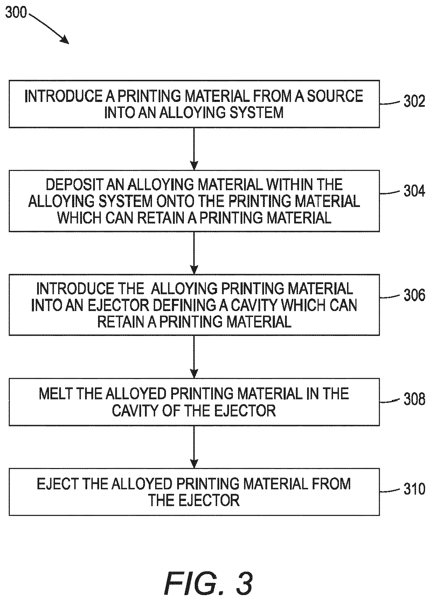

FIG. 3 is a flowchart illustrating a method of metal jetting an alloyed metal, according to an embodiment. FIG. 3 illustrates the steps of a method for metal jetting 300, including a first step to introduce a printing material from a feed source into an alloying system 302. The alloying system may include a physical vapor deposition process, such as a sputter deposition process. Alternate embodiments may incorporate an alloying system with either an electroplating process, an electroless plating process, a chemical vapor deposition process or other alloying or deposition processes as described herein. The printing material may include a wire, a rod, or other material source. The method for metal jetting 300 next includes the steps to deposit an alloying material within the alloying system onto the printing material to produce an alloyed printing material 304 and to introduce the alloyed printing material into an ejector defining a cavity which can retain a printing material 306. Once the alloyed printing material is introduced into the ejector, the next step in the method for metal jetting 300 is to melt the alloyed printing material in the cavity of the ejector 308, and to eject the alloyed printing material from the ejector 310.

Alternate embodiments of the method for metal jetting 300 may include mixing the printing material and the alloying material within the cavity of the ejector after introducing the alloyed printing material into the cavity of the ejector. Certain embodiments may include an external mixing element, or the mixing may rely on convection currents or eddy currents within the molten material inside the malt pool or ejector cavity. Other exemplary embodiments of the method for metal jetting 300 may include adjusting an amount of the alloying material relative to an amount of the printing material by adjusting a feed rate of the printing material.

In certain embodiments, the method for metal jetting 300 may include adjusting an amount of the alloying material relative to an amount of the printing material by adjusting a parameter in the alloying system. The printing material used in the method for metal jetting 300 may include a metal, metallic alloys, or a combination thereof, such as aluminum, aluminum alloys, or a combination thereof. Likewise, the alloying material in the method for metal jetting 300 may include a metal, element, metallic alloys, or a combination thereof. In certain embodiments, strontium is an example alloying material. The content of alloying material in exemplary embodiments in the alloyed printing material may be from about 0.1 % to about 10 % of total weight of the alloyed printing material. Trace amounts of alloyed material may be on the order of from 1 parts per million (ppm) to about 10 parts per million (ppm), or up to 200 parts per million (ppm) relative to the total weight of alloyed printing material.

It should be noted that advantages of embodiments as described herein may include the use of an in-process method to make custom compositions of alloyed metals. There may be a further opportunity to create a gradient of alloyed metals that could create printed parts with gradient chemical compositions. Additional advantages of exemplary embodiments as described herein include cost savings by alloying inline as opposed to custom ordering alloy compositions, improved quality of resulting printed parts will have higher quality due to the trace elements improving printed part properties such as solidification and interlayer adhesion. Adding trace amounts of alloying elements should result in a positive impact on properties such as oxidation to improve interlayer adhesion, solidification, and other microstructure properties. Such a small change in alloy composition may impact specific aspects of the material but still remain relatively insignificant with respect to the physical properties in the molten state with respect to jetting parameters. Furthermore, as the amount of trace alloying elements to be added may be within the range of the variation of other stock materials, it would not be likely that jetting parameters would be negatively influenced.

Certain embodiments of the method for metal jetting modified metal 400 may include the step of introducing an additive to the first gas from a second source 404 which includes heating a solid to form a vaporized solid, and alternatively combining the vaporized solid with a second gas from a second gas source. In exemplary embodiments, the vaporized solid may include a grain refiner, such as strontium, or other vaporized solids, such as calcium. The method for metal jetting modified metal 400 may also include ejecting a droplet of molten metal printing material from the ejector nozzle, allowing the combination of the first inert gas and the particles suspended in the second inert gas to react with the droplet of molten metal printing material to form a modified molten metal printing material, or depositing a droplet of the modified molten metal printing material onto a substrate or a solid printing material. Alternate embodiments of the method for jetting modified metal compositions may include modification of concentrations of additives during the process, or "on the fly." The ratio of deposition may be controlled by controlling or changing the ratio of flow rates, such as by regulating pressure of gas sources or other process controls. Further embodiments of the method for jetting modified metal compositions may include changing a composition of a printed part from layer to layer. The modification may also be employed or enacted in an intermittent fashion by turning on and turning off the modification process or additive source input into the system.

The method for jetting modified metal compositions may include forming a weak boundary layer for a "breakaway" section or interface between a support structure and a product structure. In certain embodiments, the adding of oxygen or other embrittling agent or additive may be used in certain areas of a part to enable more facile separation of support structure from the main or desired printed component or part. Breakaway supports or interfaces may also be constructed by metering out additives or printing material compositions in a variable manner only at specific points or printed parts portions as needed. For example, a secondary gas regulator may be turned on, turned off, or regulated to deliver a quantity of additive to provide properties facilitating a breakaway or easily separate component portion. This method may create a chemical or physical layer disruption as well as a compositional disruption resulting in easier breakage at a specific location in a part structure.

While the present teachings have been illustrated with respect to one or more implementations, alterations and/or modifications may be made to the illustrated examples without departing from the spirit and scope of the appended claims. For example, it may be appreciated that while the process is described as a series of acts or events, the present teachings are not limited by the ordering of such acts or events. Some acts may occur in different orders and/or concurrently with other acts or events apart from those described herein. Also, not all process stages may be required to implement a methodology in accordance with one or more aspects or embodiments of the present teachings. It may be appreciated that structural objects and/or processing stages may be added, or existing structural objects and/or processing stages may be removed or modified. Further, one or more of the acts depicted herein may be carried out in one or more separate acts and/or phases. Furthermore, to the extent that the terms "including," "includes," "having," "has," "with," or variants thereof are used in either the detailed description and the claims, such terms are intended to be inclusive in a manner similar to the term "comprising." The term "at least one of' is used to mean one or more of the listed items may be selected. Further, in the discussion and claims herein, the term "on" used with respect to two materials, one "on" the other, means at least some contact between the materials, while "over" means the materials are in proximity, but possibly with one or more additional intervening materials such that contact is possible but not required. Neither "on" nor "over" implies any directionality as used herein. The term "conformal" describes a coating material in which angles of the underlying material are preserved by the conformal material. The term "about" indicates that the value listed may be somewhat altered, as long as the alteration does not result in nonconformance of the process or structure to the illustrated embodiment. The terms "couple," "coupled," "connect," "connection," "connected," "in connection with," and "connecting" refer to "in direct connection with" or "in connection with via one or more intermediate elements or members." Finally, the terms "exemplary" or "illustrative" indicate the description is used as an example, rather than implying that it is an ideal. Other embodiments of the present teachings may be apparent to those skilled in the art from consideration of the specification and practice of the disclosure herein. It is intended that the specification and examples be considered as exemplary only, with a true scope and spirit of the present teachings being indicated by the following claims.

## Claims

1. A method for metal jetting, comprising:
introducing a printing material from a feed source into an alloying system;
depositing an alloying material within the alloying system onto the printing material to produce an alloyed printing material;
introducing the alloyed printing material into an ejector defining a cavity which can retain a printing material;
melting the alloyed printing material in the cavity of the ejector; and
ejecting the alloyed printing material from the ejector.

2. The method for metal jetting of claim 1, wherein the printing material further comprises a wire or a rod.

3. The method for metal jetting of claim 1, wherein the alloying system comprises a physical vapor deposition process.

4. The method for metal jetting of claim 3, wherein the physical vapor deposition process further comprises a sputter deposition process.

5. The method for metal jetting of claim 1, wherein the alloying system comprises an electroplating process.

6. The method for metal jetting of claim 1, wherein the alloying system comprises an electroless plating process.

7. The method for metal jetting of claim 1, wherein the alloying system comprises a chemical vapor deposition process.

8. The method for metal jetting of claim 1, further comprising mixing the printing material and the alloying material within the cavity of the ejector after introducing the alloyed printing material into the cavity of the ejector which can retain a printing material.

9. The method for metal jetting of claim 1, further comprising adjusting an amount of the alloying material relative to an amount of the printing material by adjusting a feed rate of the printing material.

10. The method for metal jetting of claim 1, further comprising adjusting an amount of the alloying material relative to an amount of the printing material by adjusting a parameter in the alloying system.

11. The method for metal jetting of claim 1, wherein the printing material comprises a metal, element, metallic alloy, or a combination thereof.

12. The method for metal jetting of claim 1, wherein the printing material comprises aluminum, aluminum alloys, or a combination thereof.

13. The method for metal jetting of claim 1, wherein the alloying material comprises a metal, element, metallic alloy, or a combination thereof.

14. The method for metal jetting of claim 1, wherein the alloying material comprises strontium.

15. The method for metal jetting of claim 1, wherein a content of alloying material in the alloyed printing material is from about 0.1% to about 10% of total weight of the alloyed printing material.

16. The method for metal jetting of claim 1, wherein a content of alloying material in the alloyed printing material is from about 1 ppm to about 200 ppm of total weight of the alloyed printing material.

17. A system for jetting metal, comprising:
an ejector defining an inner cavity;
a nozzle orifice in connection with the inner cavity and configured to eject one or more droplets of liquid metal;
a source of printing material located external to the ejector; and
an alloying system located between the source of printing material and the ejector; and
wherein the source of printing material is configured to introduce the printing material into the alloying system and then into the inner cavity of the ejector.

18. The system for jetting metal of claim 17, further comprising a heating element configured to heat a solid in the inner cavity of the ejector, thereby causing the solid to change to a liquid within the ejector.

19. The system for jetting metal of claim 17, further comprising:
a coil wrapped at least partially around the ejector; and
a power source configured to supply one or more pulses of power to the coil, which cause the one or more droplets of liquid metal to be jetted out of the nozzle orifice.

20. The system for jetting metal of claim 17, wherein the alloying system comprises a physical vapor deposition apparatus.
